# EUROPEAN PATENT SPECIFICATION

(11) **EP 0 695 918 B1**
(45) Date of publication and mention of the grant of the patent: **04.06.1997**
(21) Application number: 95305016.8
(22) Date of filing: 19.07.1995
(51) Int. Cl.: F24F 11/00, G01R 31/28, G01R 31/36

(54) **Safety apparatus**
Sicherheitsvorrichtung
Dispositif de sécurité

(30) Priority: 05.08.1994 GB 9415837
(43) Date of publication of application: 07.02.1996
(73) Proprietor: COLT INTERNATIONAL HOLDINGS A.G., CH-6340 Walterswil/Baar (CH); COLT INTERNATIONAL LICENSING LIMITED, Hampshire PO9 2LY (GB)
(72) Inventor: Coulter, Ian James Hamilton, Bishops Waltham, Hants SO32 1BY (GB); Morrison, Simon Peter Anthony, Southsea, Hants (GB); Roberts, Carl Reginald, Fareham, Hants PO15 5HF (GB)
(74) Representative: Greenwood, John David

(56) References cited:
- GB-A- 2 194 327
- US-A- 5 325 041

## Description

This invention relates to safety apparatus which includes a component having at least a first state and an emergency state. Examples are fire safety apparatus such as ventilators for venting smoke from a burning building and smoke curtains for restricting the spread of smoke in a burning building.

A ventilator is generally movable between a closed position (first state), through various partially open positions (intermediate states) and a fully open position (emergency state) which last position is the one adopted to provide maximum venting of smoke. Such ventilators can also be used to provide normal day-to-day ventilation, the degree of opening or number of the ventilator(s) being determined by the amount of ventilation required at any given time.

A smoke curtain has two operative states, a raised state (first state) in which the curtain is retained within a ceiling cavity of a room, for example, and a dropped or lowered state (emergency state) in which the curtain has been lowered to the floor to divide a room into different zones to contain smoke to one side of the curtain. Such smoke curtains can be raised and lowered in the absence of an emergency, for example to carry out routine testing of the equipment.

A common feature of the ventilator and smoke curtain described above is that they are generally arranged to be movable to their respective emergency state when there is no emergency in force, for example, for day-to-day ventilation or testing. The components are generally movable between their various states by operating means under the control of a control means.

In safety critical applications in which the component must be movable to the emergency state during an emergency, it is desirable that the apparatus fails safely by moving to the emergency state if the apparatus breaks down so it will be in the appropriate state should an emergency arise before it is repaired. In the context of ventilators, for example, it is very common to maintain the vent in its closed position by means of pneumatic pressure acting against a local, spring-driven actuator or spring so that on failure of the pneumatic supply, the spring driven actuator or spring moves the vent to the open (emergency) state.

Day-to-day ventilation can be provided by altering the pneumatic pressure to open and close the ventilator as required. If an emergency is detected, the pneumatic pressure is released by the controller so the ventilator moves to its open position if it was not already open.

Electrical operating means have also been employed in which the spring force of an actuator is resisted by a solenoid clutch and an electric motor. If the electrical supply to the motor fails, the ventilator is again opened by the spring driven actuator or spring.

Similarly, smoke curtains can be controlled such that they can be raised and maintained in the raised position by the action of an electric motor but should the source of electrical power needed to drive the motor fail, the smoke curtain drops under the force of gravity acting on weights attached to the bottom of the curtain, for example, to the lowered, emergency position.

A disadvantage of pneumatically controlled systems is the considerable cost associated with the pipework and compressors. Further disadvantages are that there is little flexibility in their control and there is no assurance that the operating means will act to move the component to the emergency state once the force keeping it in the first state is removed. For example, the spring in the above described ventilator may break or the frictional forces associated with poorly maintained bearings of the smoke curtain may prevent it dropping under gravity.

Electrically operated actuators in such apparatus would require a well protected source of electricity and, in the case of electric motor operated components, would often need to be supplied with a high electrical current so the component could be moved between states quickly. The wiring through the building would therefore require a high current carrying capability.

GB-A-2,194,327 discloses a system for opening louvre ventilators which include an electric motor provided at each ventilator for opening or closing the ventilator, each motor being powered by an independent source, for example a trickle charged battery, which itself is kept sufficiently charged by connection to the mains. This application states that the battery/charger motor unit is preferably self contained and can provide for up to 100 operations after failure of the electrical supply. This system of GB-A-2,194,327 is as recited in the preamble of claim 1, that is a safety apparatus including a component having at least a first state and an emergency state and movable between the states by one or more actuators under the control of a controller in which the actuators are powered solely by an energy storage means arranged to be recharged at a rate which is smaller than the rate of discharge when powering the actuators.

The battery/charger motor unit of GB-A-2,194,327 may, it is stated, also include electronic circuitry comprising means, amongst others, to automatically check the condition of the battery and warn of impending failure.

The present invention is characterised by including energy level monitoring means arranged to monitor the energy stored in the energy storage means to determine if the energy stored in the energy storage means has fallen below a predetermined threshold at which there is sufficient energy in the energy storage means to provide at least a predetermined number of movements of the component between the first state and the emergency state
and by the controller having a first control mode in which the controller is able to respond to emergency commands, only, to move the component from the first state to the emergency state and a second control mode in which
the controller is able to respond to non-emergency commands to move the component between the first state and the emergency state, the controller being arranged to switch to the first control mode when the energy stored in the energy storage means has fallen below the first threshold level.

The apparatus preferably includes an indication means coupled to the monitoring means arranged to provide a visual indication if the energy stored in the energy storage means has fallen below the predetermined threshold. This could be a slowly flashing light or the switching off of an otherwise continuously or intermittently lit light, for example. In some circumstances a non-visual indication may be convenient, for example an audible alarm, instead of or as well as the visual indication.

The present invention provides the ability to drive, with safety, relatively high powered, remote actuators used to move the component between states with a low power supply to the energy storage means of the apparatus because the monitoring means determines when non-emergency use should cease in order to ensure there is enough energy in the energy storage device to move the component to the emergency state should an emergency arise. The first threshold is set at a level at which there is sufficient energy in the energy storage means to provide at least a predetermined number of movements, for example four, between the first state and the emergency state.

The controller may be further arranged to move the component to the emergency state if the energy level falls below a second threshold, for example a threshold which corresponds to two movements between the first state and emergency state. The provision of a warning at the first threshold level before an automatic movement to an emergency state when the available energy in the energy storage means falls below the second threshold can allow time for remedial action to be taken before the component adopts its safe but perhaps inconvenient emergency state.

The controller has a first control mode in which the controller is able to respond to emergency commands, only, to move the component between the first state and the emergency state and a second control mode in which the controller is able to respond to non-emergency commands to move the component between the first state and the emergency state, the controller being arranged to switch to the first control mode if the energy stored in the energy storage means has fallen below the first threshold level.

This configuration ensures the component cannot be moved between states except via emergency commands, either automatically generated in response to the detection of fire, smoke or other emergency or manually input by firemen, for example, if the energy level of the energy storage means falls below the first threshold. It will be appreciated that emergency commands can be used to move the component to any of its states, not just the emergency state: it may be necessary to close a smoke vent to prevent wind blowing into a burning building even though the emergency state of the vent would be the open position to allow smoke to vent from the building, for example.

The apparatus may be arranged so that the controller also moves to the first control mode on receipt of an emergency alarm signal. This is the preferred arrangement of the invention.

Non-emergency ("day-to-day") operation is possible when the controller is in its second control mode. For example, a ventilator could be moved between the open and closed position as desired, either manually or automatically in response to detected environmental conditions.

The controller may be arranged to move the component to a selected state on moving to its first control mode. For example, the ventilator may be moved to the closed position for security reasons, perhaps, where it will remain until an emergency is detected, an emergency "open" command is issued or the controller is moved out of this first control mode. It may be preferable in some circumstances for the controller to move the component to its emergency state on moving to the first control mode so that it immediately adopts a fail-safe condition.

The apparatus may be arranged so that the selected state is alterable by, for example, a switch or a movable jumper lead on a printed circuit board of the controller.

Although the invention provides that the controller is not able to move the component to the emergency state except in response to an emergency command when in its first control mode, the apparatus may be configured to allow movement of the component to others of its states. For example, the controller may be arranged to allow closure, only, of a ventilator, when in the first control mode so if the controller is moved to its first control mode when the ventilator is already open, ie in the emergency state, it can remain there for a time and the ventilator subsequently closed in stages perhaps, as the requirements of day-to-day ventilation dictate. However, once closed, the controller if it remains in the first control mode will move the ventilator back to or towards the emergency, open, state only in response to an emergency command.

The controller may be arranged so that whichever control mode it is in, it will automatically move the component to its emergency state on detection of an emergency. In the case of a ventilator or smoke curtain, the detection of smoke or heat, for example, might cause the controller to open the vent or lower the smoke curtain.

The apparatus may be provided with sensors near the location of the component so locally derived emergency signals can be obtained and the controller arranged to go into its first control mode and to move the component to its emergency state on local detection of an emergency so the component operates appropriately even if remote parts of the emergency control system fail due to the emergency itself.

The energy storage device can be selected from a range of devices. It can be a battery trickle charged by a wire connectable to mains power supply of a building or a solar cell with relatively large current capacity wires being needed only between the batteries and the actuators. The battery could be trickle charged by way of a direct current trickle charge current carried on a twisted wire pair, which twisted wire pair also carries command signals to the associated controller from a central controller.

An alternative device is a spring mechanism, for example a clockspring driven at one end by a small electric motor. The other end of the clockspring would be arranged to open and close the ventilator, for example, via a crank. Several operational cycles of the component should be available when the spring has the maximum energy stored. The controller monitors the number of rotations of the electric drive and the component movement to determine the number of operational cycles that can still be obtained from the energy in the spring mechanism at any given time.

Preferably a solenoid-driven brake or latch is provided (possibly a bistable arrangement which would not require continuous power to be applied to the solenoid), to stop the spring from unwinding at the appropriate open and closed positions. A 'trickle-charging' low-current wire would drive the electric motor.

Other, alternative, energy storage devices are fluid accumulators, for example a pneumatic accumulator or a hydraulic accumulator, both of which can be 'trickle charged' using small bore pipes.

The energy storage devices are ideally positioned close to each component's actuators.

An apparatus according to the present invention can have two or more components, for example adjacent ventilators, controlled by a single controller.

An embodiment of the invention will now be described, by way of example only, with reference to the accompanying drawings of which:
Figure 1 is a schematic diagram of a smoke ventilation and control system incorporating a ventilator and a smoke curtain, each according to the present invention; and
Figure 2 is a schematic diagram of the controllers of the system of Figure 1.

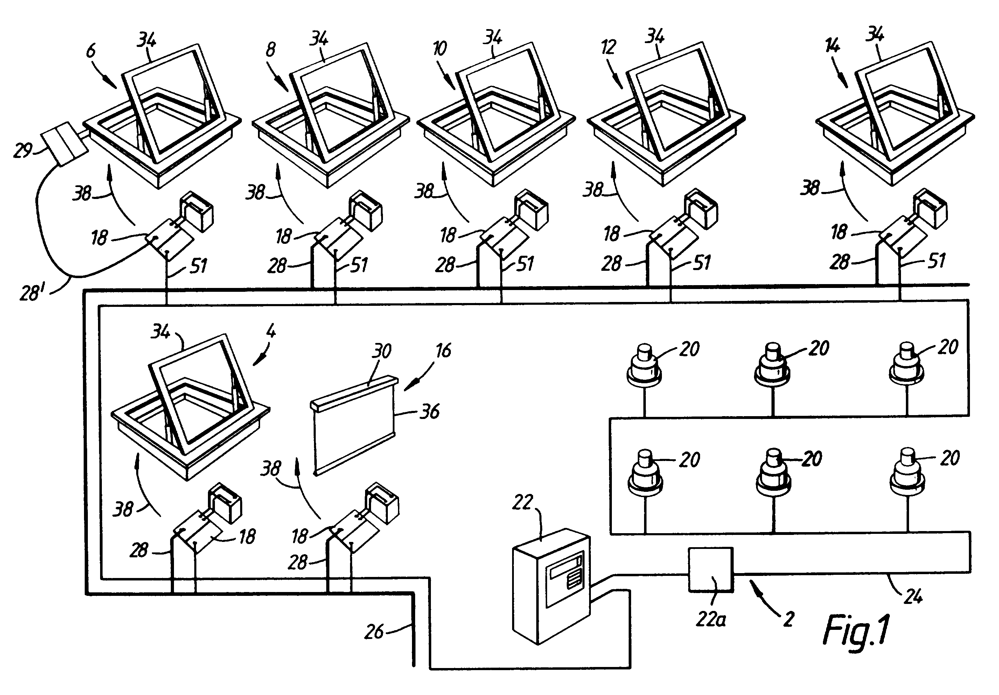

Referring to Figure 1, a smoke ventilation and control system includes seven ventilator apparatus 4 to 14 and a smoke curtain apparatus 16, each including a controller 18, six fire/smoke detectors 20 and a central controller 22. The central controller 22 communicates with the controllers 18 via a communications bus 24. Each controller 18 is linked to a mains power cable 26 via a respective low current capacity spur wires 28.

The ventilators 4 to 14 are located in a building at positions from where smoke is to be vented in the event of a fire. The smoke curtain apparatus 16 has a housing 30 which is fixed to the ceiling or within a ceiling cavity (not shown) at a position where the passage of smoke, across a large room for example, is to be constrained.

The fire/smoke sensors 20 are positioned throughout the building in appropriate places to provide early detection of fire or smoke. The sensor outputs are collated by a known fire alarm panel 22a connected to the controller 22.

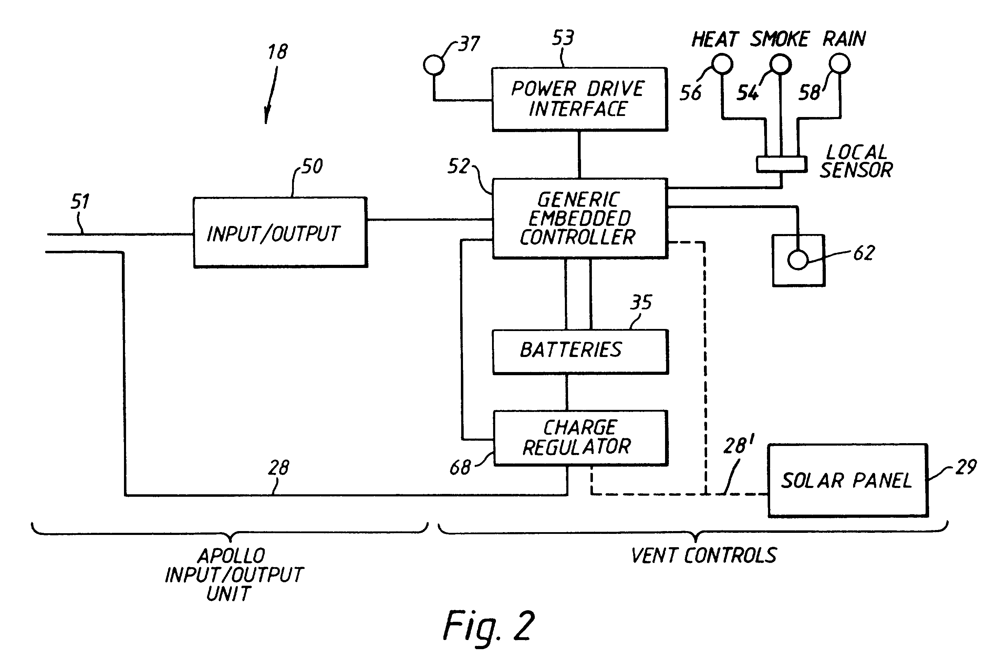

The ventilators 4 to 14 are Kameleon Mk III Ventilators manufactured by Colt International Limited, Havant, Hampshire PO9 2LY, England, each of which has a hinged glass vent 34 movable between a closed position to the illustrated open position by means of electric motors 37 (see Figure 2) powered by batteries 35. They can also be moved to intermediate positions between these two extremes. The open position is the emergency state of this component as it is the state adopted in the event of a fire to allow smoke to vent from the building.

A smoke curtain 36 of the smoke curtain apparatus 16 is movable into and out of the housing 30 by means of an electric motor driving a roller (not shown) within the housing 30. The lowered position of the curtain 36 is the emergency state of the smoke curtain apparatus 16.

The operation of each of the ventilators 4 to 14 and the smoke curtain 16 is controlled by the associated controller 18, as indicated schematically by the arrows 38, each connected to the central controller 22. As will be explained in more detail below, the controllers 18 and central controller 22 provide a distributed control system in which each controller 18 has sufficient control and communications electronics to be controlled from the main control panel or to act independently if the need arises.

The controllers 18 each have at least two control modes; a first control mode in which the controller 18 is able to respond to emergency commands, only, to move its associated component (ventilator 4 to 14 or smoke curtain 16 in this particular example) and a second control state in which the controller 18 is able to move the component between the first state and the emergency state in response to non-emergency commands. The controllers 18 therefore allow operation of the ventilators to meet day-to-day ventilation requirements or of the smoke curtain 36 for testing until the controller 18 is moved into the first control mode when emergency command operation, only, is possible.

The commands for day-to-day operation can be derived from manual input at the central controller 22, automatic control routines in the central controller 22 or controllers 18 influenced by readings from sensors (including environmental sensors such as temperature sensors).

The central controller 22 uses conventional control techniques and the Apollo control signal protocol available from Apollo Fire Detectors Ltd, 6 Solent Road, Havant, Hampshire P09 1JH. The communications bus 24 links the central controller 22 to the controller 18 in a known manner. The controllers 18 are based on a commercially available control chip set sold in the UK by Apollo.

Methods of designing hardware and software to provide a robust control system are well known and will not be explained in detail in this application.

Referring now to Figure 2, a controller 18 has an input/output module 50 which provides the interface between the controller 18 and the central controller 22 via spurs 51 of the communications bus 24.

The heart of each controller 18 is a generic microprocessor embedded controller 52. The only significant difference between the controllers 18 appropriate to different ventilators and smoke curtains is the power drives required for different types of motors - the controls and communication sub-systems remain universal. This approach to design is preferred as it increases system flexibility and keeps manufacture to a minimum.

The main functions of the embedded controller 52 are:-
1. read command data from the central controller 22;
2. send status information back from a ventilator 12 or smoke curtain apparatus 16 over the communication subsystem;
3. monitor data from a local smoke sensor 54, a local or nearby heat sensor 54 and a local rain sensor 56 mounted on the ventilator and/or in ventilator zones and act on the sensed information as required;
4. prioritise incoming information;
5. monitor the battery 35 and solar panel 29 (if fitted) to maintain safe operation;
6. send the necessary signals to the vent motor drives 37 via power drive interfaces 53 for day-to-day or emergency operation;
7. monitor the status of the electric motors 37 and associated drive electronics;
8. drive a visual diagnostics lamp which provides a visual indication of the operational status of the ventilator by flashing if the ventilator is fully operational and providing steady light if it is not; and
9. maintain control over a current conservation function.

The local heat sensor 56 and smoke sensor 54 provide a safety backup to the main fire alarm central control. The heat sensor 56 and rain sensor 58, strategically mounted within zones inside and outside the building are used for general ground monitoring and automatic comfort ventilation control.

Data from all the sensors 54 to 58 can be fused in order to provide the local control system with "intelligent" information, for example a combination of low temperature, moisture and lack of current from the solar cell could indicate the presence of snow. The necessary action can then be taken.

The battery is charged via a charge regulator 68 electrically connected to a mains supply 26 via one of the spurs 28 and/or to a solar panel 29 via a spur 28' under the control of the generic controller 52.

The charge state of the battery is monitored as follows.

The only two variables used in this exemplary embodiment for ascertaining the state of the battery during use are battery voltage and battery impedance.

An input to an A to D converter is used to monitor the battery voltage, samples being taken continually and grouped as to whether the battery is on charge, on load, or idle. Approximate values of the battery impedance are measured by periodically (approx every 10 seconds) connecting a resistor across the battery for 42ms. The voltages measured, just before the connection and subsequent disconnection of the resistor, are used to estimate the battery impedance. Samples taken are used by the generic controller 52 to set error flags if the battery is faulty or in a state of low charge.

If either the low charge flag or battery faulty flag is set, this information is communicated to the Apollo interface as an error code. Additionally, the state of these flags can be obtained by the controller 22 via the bus 24 by requesting a status report. Should the flags be set, a visual indication is given by flashing the visual diagnostics lamp 62 (a red lamp). The lamp 62 is used to communicate any error condition, not just battery faults: the status report allows the user to determine precisely what has happened.

The following charger fault flags are also defined: low-input-charging-volts, transformer-fuse-blown, control-wire-fuse-blown, current-has-tapered-back and mechanical failure flags. The current-has-tapered-back flag is set if the charging current has, in this example, falls below 0.4A. The battery-faulty flag and the transformer-fuse-blown flag will be set if these conditions occur, and can only be cleared should the controller 18 be reset or a reset command is received from the central controller 22. The other flags are transient, being set if the condition exists and cleared if the controller 18 affected determines that the conditions no longer exist. The control-wire-fuse-blown flag has no use in this embodiment but is included to allow ready software development for other embodiments. In this embodiment this flag is always set to 0.

A software charge integration procedure is also included. This procedure monitors digitised samples of charging current Qin and motor current Qout, and uses these values to keep track of the available energy remaining in the battery. Initialisation algorithms set the value in charge accumulator computer store, both at initial power up, and during the running of the controller 18, to prevent the charge accumulator drifting out of bounds.

If the charge accumulator indicates that the remaining available energy in the battery is below a specified first threshold, the generic controller 18 is moved to its first control mode to inhibit the opening of the ventilator except on receipt of emergency commands, the battery-discharged flag is set and the indicator lamp 62 is made to flash.

The battery-discharge flag is set when the algorithms of the generic controller 52 indicate that the remaining charge in the battery can only support a given number, for example four, of further opening operations. Whilst this flag is set, day-to-day ventilation operations are inhibited.

The system of Figure 1 operates as follows:

The ventilators 4 to 14 and smoke curtain 16 are operated to meet day-to-day requirements either by manual input to the central controller 22 or automatically as determined by the central controller 22 or controllers 18. For example, a ventilator controller 18 can be arranged to open its associated ventilator if either the wind speed or air moisture level or rain is greater than some preset level and there is no emergency. If, however, a battery fault is detected or its stored energy level drops below a predetermined first threshold the associated controller 18 moves to its first control mode and controls the motor of the associated ventilator to move it to one of its operation states. In this embodiment a ventilator is moved to the closed position, and the smoke curtain 16 of the smoke screen 36 is retracted into the housing 30.

The affected controller 18 now will only move the ventilator or smoke curtain to its emergency state, that is fully open or fully lowered, respectively, in response to emergency commands or if an emergency is detected.

In this embodiment, the controller 18 will also operate the component in this manner if fire or smoke is detected by one of the fire/heat sensors 20 or a local heat or smoke sensor 54 or 56 or if a fusible link blows.

The controller 18 will move out of the first control mode to the second or other control mode once the battery charge level is above the threshold level, any battery fault has cleared, and no emergency is detected.

If the battery discharges further to below a second threshold level when only two ventilator opening or smoke curtain dropping operations are possible, for example, the apparatus fails-safely by automatically moving the ventilator and smoke curtain to the open and lowered, emergency state, respectively.

## Claims

1. Safety apparatus including a component (34) having at least a first state and an emergency state and movable between the states by one or more actuators (57) under the control of a controller (18) in which the actuators (57) are powered solely by an energy storage means (35) arranged to be recharged at a rate which is smaller than the rate of discharge when powering the actuators and characterised by including energy level monitoring means arranged to monitor the energy stored in the energy storage means (35) to determine if the energy stored in the energy storage means (35) has fallen below a predetermined threshold at which there is sufficient energy in the energy storage means (35) to provide at least a predetermined number of movements of the component (34) between the first state and the emergency state and by
the controller (18) having a first control mode in which the controller (18) is able to respond to emergency commands, only, to move the component from the first state to the emergency state and a second control mode in which
the controller (18) is able to respond to non-emergency commands to move the component between the first state and the emergency state, the controller (18) being arranged to switch to the first control mode when the energy stored in the energy storage means (35) has fallen below the first threshold level.

2. An apparatus as claimed in claim 1 including an indication means (62) coupled to the monitoring means arranged to provide a visual indication if the energy stored in the energy storage means (35) has fallen below the predetermined threshold.

3. An apparatus as claimed in claim 1 or 2 in which the controller (18) is arranged to move the component (34) to a selected one of the states of the component (34) on moving to its first control mode; and, optionally, either or both of
a) the selected one of the states of the component (34) is alterable; and
b) the selected state is the emergency state of the component (34).

4. An apparatus is claimed in any preceding claim in which the component (34) is a ventilator which is closed in the first state and open in the emergency state.

5. An apparatus as claimed in any preceding claim in which the energy storage device comprises a spring mechanism coupled to an electric motor, a battery (35), or a fluid accumulator.

6. An apparatus as claimed in claim 5 in which the energy storage device is a battery (35) which is trickle charged.

7. An apparatus as claimed in claim 6 in which the battery (35) is trickle charged by way of one or more wires (28) connectable to a mains power supply (26) of a building or by a solar cell (29), or in which the battery (35) is trickle charged by way of a direct current trickle charge current carried on a twisted wire pair, which twisted wire pair also carries command signals to the associated controller (18) from a central controller (22).

8. An apparatus as claimed in any preceding claim and including local environmental sensors (54, 56, 58) coupled to the controller (18) which is arranged to be able to operate on the basis of locally derived environmental information from the sensors if desired, which sensors may, optionally, include one or more of a heat sensor (56), smoke sensor (54) and rain sensor (58).

9. An apparatus as claimed in any preceding claim in which there are two or more components (34) controlled by a single controller (18).

## Patentansprüche

1. Sicherheitsvorrichtung mit einem Bauteil (34), das zumindest einen ersten Zustand und einen Notzustand aufweist und zwischen den Zuständen durch ein oder mehrere Betätigungsglieder (57) unter der Kontrolle eines Steuergerätes (18) bewegbar ist, wobei die Betätigungsglieder (57) allein durch eine Energiespeichereinrichtung (35) kraftbetrieben sind, die so eingerichtet ist, daß sie mit einer Rate wieder aufgeladen wird, die kleiner ist als die Entladungsrate beim Antrieb der Betätigungsglieder, dadurch gekennzeichnet, daß eine Einrichtung zur Überwachung des Energieniveaus vorgesehen ist, die so eingerichtet ist, daß die in der Energiespeichereinrichtung (35) gespeicherte Energie überwacht wird, um zu bestimmen, ob die in der Energiespeichereinrichtung (35) gespeicherte Energie unter einen vorbestimmten Schwellwert gefallen ist, bei dem ausreichend Energie in der Energiespeichereinrichtung (35) vorhanden ist, um zumindest eine vorbestimmte Anzahl von Bewegungen des Bauteils (34) zwischen dem ersten Zustand und dem Notzustand herbeizuführen, und daß
das Steuergerät (18) eine erste Steuerart, bei der das Steuergerät (18) nur auf Notbefehle antworten kann, um das Bauteil aus dem ersten Zustand in den Notzustand zu bewegen, und eine zweite Steuerart aufweist, bei der
das Steuergerät (18) auf Nicht-Notbefehle antworten kann, um das Bauteil zwischen dem ersten Zustand und dem Notzustand zu bewegen, wobei das Steuergerät (18) derart eingerichtet ist, daß auf die erste Steuerart geschaltet wird, wenn die in der Energiespeichereinrichtung (35) gespeicherte Energie unter das Niveau des ersten Schwellwertes gefallen ist.

2. Vorrichtung nach Anspruch 1, mit einer mit der Überwachungseinrichtung verbundenen Anzeigeeinrichtung (62), die so eingerichtet ist, daß sie eine visuelle Anzeige abgibt, wenn die in der Energiespeichereinrichtung (35) gespeicherte Energie unter den vorbestimmten Schwellwert gefallen ist.

3. Vorrichtung nach Anspruch 1 oder 2, bei der das Steuergerät (18) so eingerichtet ist, daß das Bauteil (34) in einen ausgewählten der Zustände des Bauteils (34) bei der Bewegung in seine erste Steuerart bewegt wird, und, wahlweise entweder oder sowohl als auch,
a) der ausgewählte der Zustände des Bauteils (34) veränderbar ist und
b) der ausgewählte Zustand der Notzustand des Bauteils (34) ist.

4. Vorrichtung nach einem beliebigen vorhergehenden Anspruch, bei der das Bauteil (34) eine Belüftungsvorrichtung ist, die im ersten Zustand geschlossen und im Notzustand offen ist.

5. Vorrichtung nach einem beliebigen vorhergehenden Anspruch, bei der die Energiespeichereinrichtung einen Federmechanismus umfaßt, der mit einem Elektromotor, einer Batterie (35) oder einem Fluidspeicher verbunden ist.

6. Vorrichtung nach Anspruch 5, bei der die Energiespeichereinrichtung eine Batterie (35) mit Pufferladung ist.

7. Vorrichtung nach Anspruch 6, bei der die Batterie (35) ihre Pufferladung über eine oder mehrere Leitungen (28), die mit dem Stromversorgungsnetz (26) eines Gebäudes verbindbar sind, oder durch eine Solarzelle (29) erhält oder bei der die Batterie (35) ihre Pufferladung über einen Gleichstrom-Pufferladestrom auf einer verdrillten Doppelleitung erhält, welche verdrillte Doppelleitung ferner Befehlssignale zum zugehörigen Steuergerät (18) von einem zentralen Steuergerät (22) führt.

8. Vorrichtung nach einem beliebigen vorhergehenden Anspruch, mit Sensoren (54,56,58) für die örtliche Umgebung, die mit dem Steuergerät (18) verbunden sind, das derart eingerichtet ist, daß es ggf. auf der Basis von örtlich abgeleiteten Umgebungsinformationen von den Sensoren arbeiten kann, welche Sensoren wahlweise einen oder mehrere Sensoren aus der Gruppe eines Wärmesensors (56), eines Rauchsensors (54) und eines Regensensors (58) umfassen können.

9. Vorrichtung nach einem beliebigen vorhergehenden Anspruch, bei der zwei oder mehr Bauteile (34) von einem einzigen Steuergerät (18) gesteuert werden.

## Revendications

1. Dispositif de sécurité comportant un composant (34) qui a au moins un premier état et un état de secours et qui est déplaçable entre les états au moyen d'un ou plusieurs actionneurs (57) commandés par un moyen de commande (18) dans lequel les actionneurs (57) sont alimentés en énergie uniquement par des moyens de stockage d'énergie (35) agencés de manière à être rechargés à une vitesse qui est inférieure à la vitesse de décharge lorsque les actionneurs sont alimentés en énergie et caractérisé par l'incorporation de moyens de contrôle de niveau d'énergie agencés pour contrôler l'énergie stockée dans les moyens de stockage d'énergie (35) pour déterminer si l'énergie stockée dans les moyens de stockage d'énergie (35) a chuté sous un seuil prédéterminé pour lequel il y a suffisamment d'énergie dans les moyens de stockage d'énergie (35) pour fournir au moins un nombre prédéterminé de mouvements du composant (34) entre le premier état et l'état de secours, et par le fait que le moyen de commande (18) a un premier mode de commande dans lequel le moyen de commande (18) est capable de répondre à des ordres de secours, seulement, pour déplacer le composant depuis le premier état jusqu'à l'état de secours et un second mode de commande dans lequel l'organe de commande (18) est capable de répondre à des ordres non de secours pour déplacer le composant entre le premier état et l'état de secours, le moyen de commande (18) étant agencé pour être commuté dans le premier mode de commande lorsque l'énergie stockée dans les moyens de stockage d'énergie (35) a chuté en dessous du premier niveau de seuil.

2. Dispositif selon la revendication 1, comportant des moyens d'indication (62) couplés avec les moyens de contrôle agencés pour fournir une indication visuelle si l'énergie stockée dans les moyens de stockage d'énergie (35) a chuté en dessous du seuil prédéterminé.

3. Dispositif selon la revendication 1 ou 2, dans lequel le moyen de commande (18) est agencé pour déplacer le composant (34) dans un des états sélectionné du composant (34) en se déplaçant dans son premier mode de commande ; et, de façon optionnelle, l'un ou l'autre ou les deux
a) dudit un des états sélectionné du composant (34) est variable; et
b) de l'état sélectionné est l'état de secours du composant (34).

4. Dispositif selon l'une quelconque des revendications précédentes, dans lequel le composant (34) est un volet d'aération qui est fermé dans le premier état et ouvert dans l'état de secours.

5. Dispositif selon l'une quelconque des revendications précédentes, dans lequel le dispositif de stockage d'énergie comprend un mécanisme à ressort couplé à un moteur électrique, une batterie (35), ou un accumulateur à fluide.

6. Dispositif selon la revendication 5, dans lequel le dispositif de stockage d'énergie est une batterie (35) qui est maintenue en charge.

7. Dispositif selon la revendication 6, dans lequel la batterie (35) est maintenue en charge au moyen d'un ou plusieurs fils électriques (28) pouvant être raccordés à une alimentation en énergie de secteur d'un bâtiment ou au moyen d'une cellule solaire (29), ou dans lequel la batterie (35) est maintenue en charge au moyen d'un courant de maintien en charge continu transporté par une paire de fils électriques torsadés, cette paire de fils électriques torsadés transportant également des signaux de commande vers le moyen de commande associé (18) à partir d'un moyen de commande central (22).

8. Dispositif selon l'une quelconque des revendications précédentes, comportant des détecteurs (54,56,58) de milieu environnant couplés au moyen de commande (18) qui est agencé de manière à être capable de fonctionner sur la base d'une information issue localement du milieu environnant provenant des détecteurs si souhaité, ces détecteurs pouvant, de façon optionnelle, comporter un ou plusieurs détecteurs de chaleur (56), détecteurs de fumée (54) et détecteurs de pluie (58).

9. Dispositif selon l'une quelconque des revendications précédentes, dans lequel il y deux composants (34) ou plus commandés par un moyen de commande unique (18).
